# EUROPEAN PATENT APPLICATION

(11) **EP 1 868 246 A1**
(43) Date of publication of application: **19.12.2007**
(21) Application number: 06729917.2
(22) Date of filing: 24.03.2006
(51) Int. Cl.: H01L 27/00

(54) **ORGANIC EL DISPLAY DEVICE, ORGANIC TRANSISTOR AND METHODS FOR MANUFACTURING SUCH ORGANIC EL DISPLAY DEVICE AND ORGANIC TRANSISTOR**

(30) Priority: 30.03.2005 JP 2005096765
(71) Applicant: Pioneer Corporation, Tokyo 153-8654 (JP)
(72) Inventor: HARADA, Chihiro c/o Pioneer Corporation, Tsurugashima-shi, Saitama 3502288 (JP); CHUMAN, Takashi c/o Pioneer Corporation, Tsurugashima-shi, Saitama 3502288 (JP); OHTA, Satoru c/o Pioneer Corporation, Tsurugashima-shi, Saitama 3502288 (JP); YOSHIZAWA, Atsushi c/o Pioneer Corporation, Tsurugashima-shi, Saitama 3502288 (JP)
(74) Representative: von den Steinen, Axel
(86) International application number: PCT/JP2006/305969
(87) International publication number: WO 2006/109526

(57) **Abstract**

It is an object to provide an organic EL display device having the organic transistor of less performance deterioration, a method of manufacturing the organic EL display device, an organic transistor, and a method of manufacturing the organic transistor.

The organic EL display device P1 covers the organic transistor 50 and has a protection film 20 protecting the organic transistor. Between the protection film 20 and the surface of the organic transistor 50, a conductive layer (an negative electrode of the organic EL element 100) 18 having conductivity is formed and an insulation film 72 insulating the surface of the organic transistor 50 and the conductive layer 18 is formed on the side of the surface of the organic transistor 50 but the conductive layer 18.

## Description

### Technical Field

The present invention relates to an organic EL display device, a method of manufacturing an organic EL display device, an organic transistor, and a method of manufacturing an organic transistor.

### Technical Background

An organic transistor is used for variety of applications. For example, it is used as a means for driving organic EL elements in the organic EL display devices.

The organic EL element is provided with electrodes on a substrate and an organic solid layer having at least a luminescent layer between the electrodes, wherein electrons and electron holes are injected into the luminescent layer in the organic solid layer from the electrodes on both sides to emit light in the organic luminescent layer and high intensity luminescence is available. Further it features wide selection of luminescent colors because luminescence of the organic compound is employed. Therefore, it is expected as a light source and an organic EL display device. Particularly, since the organic EL display device generally has high visual field, high contrast, high-speed responsibility, excellent visibility, thin shape and light weight, it is expected as a low-power-consumption flat panel display.

The organic EL display device includes pixels having at least a positive electrode, an organic luminescent layer, a negative electrode and a transistor for lighting and controlling the organic EL element. There are two types of driving organic EL display devices - a passive matrix method and an active matrix method. In the passive matrix method, the organic EL elements arranged in a matrix shape are driven from the outside with a stripe-like scan electrode and data electrode (signal electrode) which are perpendicular to each other. In the active matrix method, a driving element, a switching element formed of thin film transistor (also refereed to as TFT hereinafter) and a memory element in every pixel are provided to light the organic EL element.

With the increasing number of pixels, generally, the active matrix method for driving the organic EL element with TFT (Thin Film Transistors) is considered more advantageous for the organic EL display device than the passive matrix method is. This is because with the passive matrix method in which the organic EL element of each pixel is lit during the period a scanning electrode is selected and the period for lighting the organic EL element tends to decrease to lower average luminance as the number of pixels increases. On the contrary with the active matrix method, each pixel has a memory element and a switching element formed of TFT, lighting state of the organic EL element is kept, high luminance, high efficiency and long-life operation are possible, therefore the active matrix method tends to be advantageous for displays of high resolution and enlarged size.

Use of the organic TFT for TFT may lead to reduction of costs and environment load. Further since the organic TFT can be produced at low process temperature, it may be produced on film substrates, and therefore, flexible displays are expected to be realized.

With regard to organic EL elements and organic TFTs, they are susceptible to erosion due to moisture and oxygen in the air, in the presence of which there may be occurrence of deterioration such as dark-spot and element short. A means for protecting elements from erosion due to moisture and oxygen in the air is necessary to protect from this deterioration. At present, a method in which elements are entirely sealed with cover glass and can packages in the atmosphere of dry nitrogen and argon gas is employed.

However, production costs of this sealing method using these glass and cans are high and there is limitation to decrease in element thickness. Then, a configuration in which organic EL elements and organic TFT are covered with protection films having a moisture-prevention function without using glass and can packages is proposed in the patent reference 1 described below.

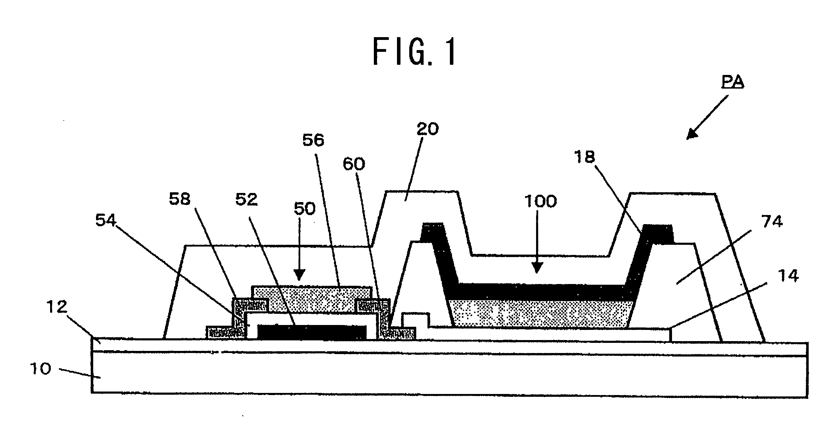

FIG. 1 shows an organic EL display device PA related to the prior art. The organic EL display device PA has a substrate 10, a barrier film 12 formed on the substrate 10, an organic EL element 100 and organic TFT 50 formed on the barrier film 12, a protection film (passivation film) 20 covering the organic EL element 100 and the organic TFT 50. Patent reference 1: Japanese Unexamined Patent Application Publication No. 2003-255857

### Disclosure of the Invention

### Problem to be Solved by the Invention

However, when the protection film is film-formed by e.g. vacuum processing of a CVD method, the organic layer and others forming the organic TFT are damaged by particle beam and electromagnetic waves which are generated from plasma produced at the time of film forming, so that performance of the organic TFT may be deteriorated.

Further, after manufacturing the protection film, the organic layer and others forming the organic TFT are damaged by at least one of electromagnetic wave and particle beam which are generated when users use and in a step of manufacturing, so that performance of the organic TFT may be deteriorated.

The present invention is made in view of the above object and main purposes of the invention are to provide an organic EL display device having organic transistor-performance which is less deteriorated, a method of manufacturing the organic EL display device, an organic transistor and a method of manufacturing the organic transistor.

### Means for Solving Problem

According to a first aspect of the present invention, an organic EL display device includes an organic EL element which is provided with at least a positive electrode, an organic luminescent layer and a negative electrode, and an organic transistor for driving the organic EL element, and the organic EL display device further comprises a protection film for covering the organic transistor to protect at least the organic transistor, wherein a conductive layer having conductivity is formed in respect of between the protection film and a surface of the organic transistor, and an insulation film for insulating the conductive layer and the surface of the organic transistor, formed on the side of the surface of the organic transistor but the conductive layer.

According to a ninth aspect of the present invention, a method of manufacturing an organic EL display device, which includes an organic EL element provided with at least a positive electrode, an organic luminescent layer and a negative electrode, and an organic transistor driving the organic EL element, comprises steps of:
forming an insulation film for insulating the conductive layer and the surface of the organic transistor;
forming a conductive layer on the insulation film; and
forming a protection film for protecting the organic transistor on the conductive layer.

According to a fifteenth aspect of the present invention, an organic transistor includes a protection film for covering the organic transistor to protect at least one of the organic transistor and further includes:
a conductive layer having conductivity, in respect between the protection film and a surface of the organic transistor; and
an insulation film for insulating the conductive layer and the surface of the organic transistor, formed on the side of the surface of the organic transistor but the conductive layer.

According to a twenty second aspect of the present invention, a method of manufacturing an organic transistor comprises steps of:
forming an insulation film for insulating the conductive layer and the surface of the organic transistor;
forming a conductive layer on the insulation film; and
forming a protection film for protecting the organic transistor on the conductive layer.

### Brief Description of the Drawings

[FIG. 1] A schematic cross sectional view for showing an organic EL display device related to prior art.
[FIG. 2] A schematic cross sectional view for showing an organic EL display device in the present embodiment.
[FIG. 3] A schematic enlarged view for showing vicinity of an organic EL element of the organic EL display device in the present embodiment.
[FIG. 4] A schematic enlarged view for showing vicinity of the organic TFT of the organic EL display device in the present embodiment.
[FIG. 5] A schematic cross sectional view for showing the organic EL display device in the present embodiment.
[FIG. 6] A schematic cross sectional view for showing the organic EL display device in the present embodiment.

### Description of the Reference Numerals

- 10: Substrate
- 16: Organic solid layer
- 18: Negative electrode
- 20: Protection film
- 50: Organic TFT
- 72, 74, 76: Insulation film
- 100: Organic EL element
- P1, P2, P3, PA: Organic EL display device

### The Best Mode for Carrying Out the Claimed Invention

Embodiments of the present invention will be described with reference to drawings hereinafter. These embodiments are just shown as exemplification to practice the present invention and the present invention is not limited by these embodiments.

### [Organic EL Display Device]

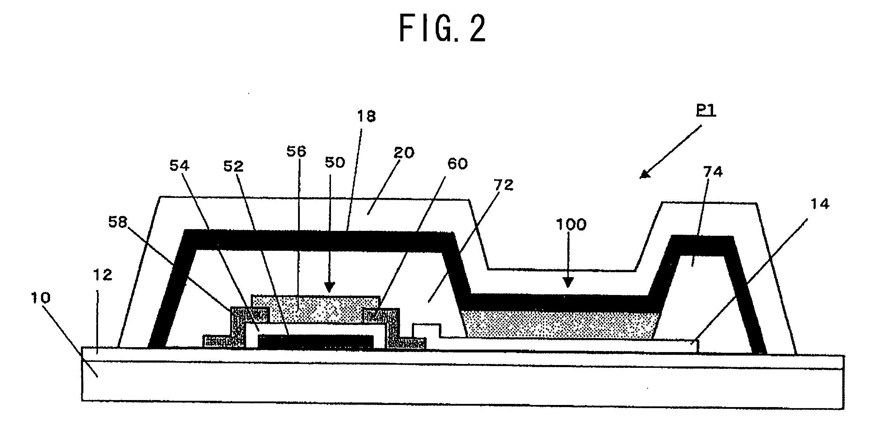

FIG. 2 is a schematic cross sectional view for showing an organic EL display device P1 related to the present embodiment. The organic EL display device P1 includes a film substrate 10, a barrier film 12 formed on the substrate 10, an organic EL element 100 and an organic TFT 50 which are formed on the barrier film 12, an interlayer insulation film 72 which covers the organic TFT 50, a negative electrode 18 of the organic EL element 100 which covers the interlayer insulation film 72, and a protection film 20 which covers a surface of the negative electrode 18 to protect the organic EL element 100 and the organic TFT 50 from erosion.

The barrier film 12 is formed on the substrate 10. The organic EL element 100 and the organic TFT 50 are disposed in parallel on the barrier film 12. The interlayer insulation film 72 is disposed on the left side of the drawing sheet in the organic EL element 100 described later and formed to reach from the top of the below described positive electrode 14 of the organic EL element 100 to the surface of the organic TFT 50 and further to a portion contact with the negative electrode 18. And an interlayer insulation film 74 for insulating the positive electrode 14 and the negative electrode 18 is disposed on the right side of the drawing sheet in the organic EL element 100 described later and formed to reach from the top of the positive electrode 14 of the organic EL element 100 to a portion contact with the negative electrode 18.
The negative electrode 18 of the organic EL element 100 described later is extended on the interlayer insulation film 72 and the interlayer insulation film 74 to cover the surface of the insulation films. The negative electrode 18 is a conductive layer and functions as a protection layer for protecting the organic TFT 50 from at least one of electromagnetic wave and particle beam. The protection film 20 covers the surface of the negative electrode 18 to protect the organic EL element 100 and the organic TFT 50 from outside erosion.

### <Substrate>

Materials of the substrate 10 may be appropriately selected and used. For example, resins used for a variety of substrates may include thermoplastic resin, thermoset resin, polycarbonate, polymethylmethacrylate, polyarylate, polyethersulfone, polysulfone, polyethyleneterephthalate polyester, polypropylene, cellophane, polycarbonate, acetylcellulose, polyethylene, polyvinyl chloride, polystyrene, polyamide, polyimide, polyvinylidene chloride, polyvinyl alchohol, ethylene-vinyl acetate copolymer saponifiables, fluorine resin, chlorinated rubber, ionomer, ethylene acrylic copolymer, ethylene acrylic ester copolymer, etc. Meanwhile resins are not principal ingredient for substrates but substrates may be glass substrates or substrates laminated with glass and plastic, or substrate surfaces may be coated with an alkali barrier film or a gas barrier film. Further, in the case of a top emission type for irradiating light from the opposite side of the substrate, the substrate 10 may not be necessarily transparent.

### <Barrier Film>

Although the barrier film 12 may not be necessarily formed, it is preferable to form the barrier film because erosion caused by moisture and oxygen generated from the substrate side can be prevented. Materials may be appropriately selected to form the barrier film 12.
The barrier film 12 may be of multilayer structure or single layer structure, and inorganic film or organic film. However, it is preferable to include the inorganic film because it improves barrier performance to prevent erosion by moisture and oxygen.

As for the inorganic film, for example, nitride film, oxide film, carbon film, or silicon film may be employed. More particularly, silicon nitride film, silicon oxide film, silicon oxide nitride film, or diamond like carbon (DLC) film, amorphous carbon film are cited. That is, cited are nitride such as SiN, AlN, GaN, oxides such as SiO, Al₂O₃, Ta₂O₅, ZnO, GeO, oxide nitride such as SiON, carbide nitride such as SiCN, metal fluoride, and metal film.

As for the organic film, cited are, for example, furane film, pyrrole film, thiophene film, polyparaxylene film epoxy resin, acrylic resin, polyparaxylene, fluorine polymer (perfluoroolefin, perfluoroether, tetrafluoroethylene, chlorotrifluoroethylene, dichlorodifluoroethylene, etc.), or polymerized film such as metal alkoxide (CH₃OM, C₂H₅OM, etc.), polyamide precursor, peril compound, etc.

As for the barrier film 12, cited are a laminated structure including two and more types of materials, a laminated structure including inorganic protection film, silane coupling layer, resin sealing film, a laminated structure including a barrier layer formed of inorganic material and a cover layer formed of organic material, a laminated structure including a compound of organics and semiconductor or metals such as Si-CXHY, and inorganic, a laminated structure in which organic and inorganic films are alternately laminated, a laminated structure in which SiO₂ or Si₃N₄ is layed on a Si layer, etc.

### <Organic EL Element>

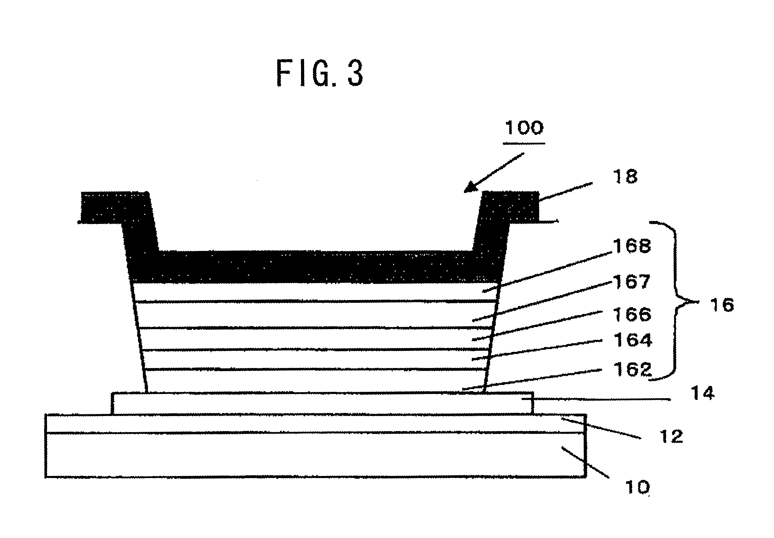

FIG. 3 is an enlarged view showing vicinity of the organic EL element 100 of the organic EL display device P1. The organic EL element 100 is configured in such that the positive electrode 14, the organic solid layer 16, and the negative electrode 18 are laminated in order from the barrier film 12 side. The lower electrode may be negative and the upper electrode may be positive and at least either one is required to be transparent.

For the positive electrode 14, the layer having such an energy level to easily inject electron holes may be used and a transparent electrode such as ITO (indium tin oxide) may be used.

The transparent conductive material such as ITO is formed into a thickness of e.g. 150 nm by spattering or others. A zinc oxide (ZnO) film, IZO (indium zinc oxide), copper iodide, etc. may be employed instead of ITO.

The organic solid layer 16 is configured in such that an electron hole injection layer 162, an electron hole transport layer 164, a luminescent layer 166, an electron transport layer 167, and an electron injection layer 168 which are laid in order from the positive electrode 14 side.

The electron hole injection layer 162 is provided between the positive electrode 14 and the luminescent layer 166 and is a layer for promoting electron holes injection from the positive electrode 14. The driving voltage of the organic EL element 100 can be lowered with electron hole injection layer 162. And in some cases, the electron hole injection layer 162 facilitates to stabilize electron hole injection so as to increase longevity of elements, and facilitates to coat convex-concave surfaces such as projection formed on the surface of the positive electron 14 so as to decrease element defects.

Materials of the electron hole injection layer 162 may be appropriately selected to meet the requirement that its ionized energy is between the work function of the positive electrode 14 and the ionized energy of the luminescent layer 166. For example, triphenylamine tetramer (TPTE), and copper phthalocyanine may be used.

The electron hole transport layer 164 is provided between the electron hole injection layer 162 and the luminescent layer 166, and is a layer for promoting electron hole transportation and has a function to appropriately transport electron holes to the luminescent layer 166.

Materials of the electron hole transport layer 164 may be appropriately selected to meet the requirement that its ionized energy is between the electron hole injection layer 162 and the luminescent layer 166. For example, TPD (triphenylamine derivative) may be employed.

The luminescent layer 166 is a layer to recombine the electron hole thus transported and the electron described later which is transported as well to emit fluorescence or phosphorescence. Materials of the luminescent layer 166 may be appropriately selected so as to satisfy the characteristics to correspond to the above-mentioned luminous mode. For example, tris(8-quinolinorate) aluminum complex (Alq), bis(benzoquinolirate) beryllium complex (BeBq), tri(dibenzoyl methyl) phenanthroline europium complex (Eu(DBM)3(Phen)), ditholilvinylbiphenyl (DTVBi), π -conjugated polymers such as poly(p-phenylenevinylene), and polyalkylthiophene may be used. For example, if green luminescence is desired, almiqunolinol complex (Alq₃) can be used.

For example, with regard to a phosphorescence emission type element, electrons and electron holes are injected into the phosphorescence layer 166 from the negative electrode 18 and the positive electrode 14 respectively to be recombined, and therefore, the recombined energy is supplied to a dopant material thorough a host material to emit phosphorescence. Here, under conditions of low injected current density, dopant-generated red luminescence is obtained in this phosphorescence-emission-type organic EL element. And under conditions of high injected current density, the host material having a luminescence emission function related to the present invention also emits light, so that added color luminescence of luminescence colors of the host material and the dopant material is obtained. For example, when using a compound emitting blue luminescence and a dopant emitting red luminescence, white luminescence synthesized by blue and red can be ejected in this organic EL element.

The electron transport layer 167 is provided between the luminescent layer 166 and the electron injection layer 168 and has a function to promote electron transportation into the luminescent layer 166.

Materials of the electron transport layer 167 may be appropriately selected so as to meet the requirement that electron affinity should be between the luminescent layer 166 and the electron injection layer 168. For example, almiquinolinol complex (Alq₃) may be used.

The electron injection layer 168 is provided between the negative electrode 18 and the electron transport layer 167 and has a function to promote electron injection from the negative electrode 18.

Materials of the electron injection layer 168 may be appropriately selected to meet the requirement that electron affinity should be between work function of the negative electrode 18 and an electron affinity of the luminescent layer 166. For example, a thin film (e.g. 0.5 nm) formed of LiF (lithium fluoride), Li₂O (lithium oxide), etc. may be employed for the electron transport layer 168.

Each layer forming the organic solid layer 16 is generally made of organic materials, particularly made of low-molecular organics and made of high-molecular organics. The organic solid layer made of low-molecular organics is generally formed by dry process (vacuum process) such as vapor deposition method, and the organic solid layer made of high-molecular organics may be generally formed by wet process such as spin coating method, plate coating method, dipping method, spraying method and printing method.

As for organic materials used for each layer forming the organic solid layer 16, for example, PEDOT, polyaniline, poly(p-phenylenevinylene) derivative, polythiophene derivative, poly(p-phenylene) derivative, polyalkylphenilane, polyacetylene derivative, etc. are cited.

Although the organic solid layer 16 including the electron hole injection layer 162, the electron hole transport layer 165, the luminescent layer 166, the electron transport layer 167, and the electron injection layer 168 is cited in the present embodiment, the organic solid layer is not limited to this configuration and the configuration may include at least the luminescent layer 166.

For example, a single-layer structure of the luminescent layer, a double-layer structure such as electron hole transport layer/luminescent layer, luminescent layer/electron transport layer, and a triple-layer structure of electron hole transport layer/luminescent layer/electron transport layer, and further a multiple-layer structure comprising an electric charge (electron hole, electron) injection layer may be included depending on characteristics of employed organic materials, etc.

Further, an electron hole blocking layer may be provided between the luminescent layer 166 and the electron transport layer 167 in the organic solid layer 16. The electron holes possibly penetrate through the luminescent layer 166 into the negative electrode 18. For example, in the case of using Alq₃ for the electron transport layer 167, there is possibility that luminescence efficiency decreases because electron holes flow into the electron transport layer to make Alq₃ emit luminescence and electron holes cannot be blocked in the luminescent layer. Therefore, the electron hole blocking layer may be provided to prevent electron holes from flowing out of the luminescent layer 166 to the electron transport layer 167.

For the negative electrode 18, materials having low work function or low electron affinity may be selected to enhance electron injection into the organic solid layer 16. For example, alloy type (mixed metal) such as Mg:Ag alloy and Al:Li alloy may be preferably used. The negative electrode 18 may be formed of metal materials such as Al, Mg, and Ag which are vacuum-evaporated into thickness of e.g. 150 nm.

### <Organic Transistor (Organic TFT) >

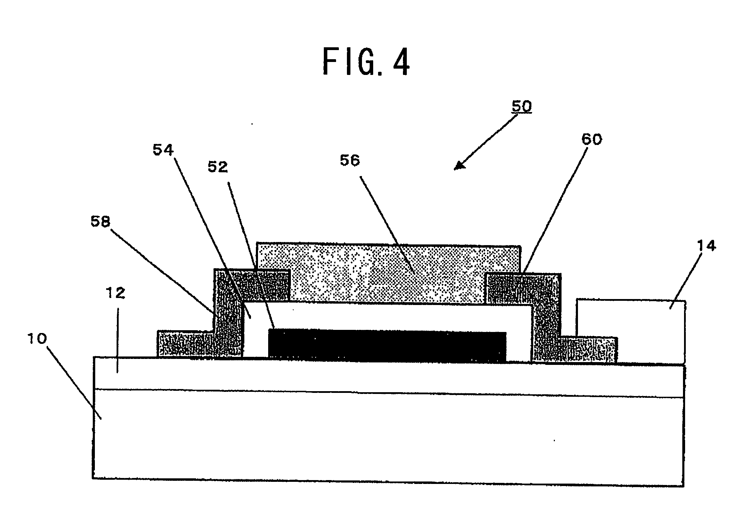

FIG. 4 is an enlarged view for showing vicinity of an organic TFT 50 of the organic EL display device P1. The organic TFT 50 has a gate electrode 52 which is formed on the barrier film 12 from the side of the barrier film 12 and a gate insulation film 54 formed to cover the surface of the gate electrode 52. An organic semiconductor layer 56 is formed on the gate insulation film 54, a source electrode 58 is formed on the left end side, and a drain electrode 60 is formed on the right end side. Here the drain electrode 60 is electrically connected with the positive electrode 14 of the organic EL element 100. That is, in the configuration of the organic TFT 50, the source electrode 58 and the drain electrode 60 are provided separately from each other, the organic semiconductor layer 56 is disposed between the source electrode 58 and the drain electrode 60, the source electrode 58, the drain electrode 60 and the organic semiconductor layer 56 are arranged so as to oppose the gate electrode 52 through the gate insulation film 54.

As for materials of the gate electrode 52, preferable may be metals capable of being anodized and simple substances or their alloys of Al, Mg, Ti, Nb, Zr, etc. However, the material is not limited to those. For the gate electrode, materials having sufficient conductivity may be included, and metal single substances, lamination or their compounds such as, for example, Pt, Au, W, Ru, Ir, Al, Sc, Ti, V, Mn, Fe, Co, Ni, Zn, Ga, Y, Zr, Nb, Mo, Tc, Rh, Pd, Ag, Cd, Ln, Sn, Ta, Re, Os, Tl, Pb, La, Ce, Pr, Nd, Pm, Sm, Eu, Gd, Tb, Dy, Ho, Er, Tm, Yb, Lu, etc. may be included. Further, metal oxides such as ITO and IZO or organic conductive materials containing conjugated polymer compounds such as, polyaniline, polythiophene, and polypyrole may be used.

A general method for forming a wiring pattern of the gate electrode 52 on the substrate 10 may be a manufacturing method of the gate electrode 52a. Although a spattering method, CVD method and others may be cited, the methods are not limited to those and appropriate methods may be appropriately used. For example, general methods for forming thin film such as film vacuum evaporation, ion plating, sol-gel method, spin coating method, spraying method, and CVD may be also possible.

With regard to the gate insulation film 54, a surface of a material used as one of the gate electrode 52 may be preferably anodized to form the gate insulation film 54. The film is not limited to those but either of inorganic materials and organic materials may be used.

For example, as for metal oxides, cited are metal oxides including LiOx, LiNx, NaOx, KOx, RbOx, CsOx, BeOx, MgOx, MgNx, CaOx, CaNx, SrOx, BaOx, ScOx, YOx, YNx, LaOx, LaNx, CeOx, PrOx, NdOx, SmOx, EuOx, GdOx, TbOx, DyOx, HoOx, ErOx, TmOx, YbOx, LuOx, TiOx, TiNx, ZrOx, ZrNx, HfOx, HfNx, ThOx, VOx, VNx, NbOx, TaOx, TaNx, CrOx, CrNx, MoOx, MoNx, WOx, WNx, MnOx, ReOx, FeOx, FeNx, RuOx, OsOx, CoOx, RhOx, IrOx, NiOx, PdOx, PtOx, CuOx, CuNx, AgOx, AuOx, ZnOx, CdOx, HgOx, BOx, BNx, AlOx, AlNx, GaOx, GaNx, InOx, TiOx, TiNx, SiNx, GeOx, SnOx, PhOx, POx, PNx, AsOx, SbOx, SeOx, TeOx, etc. and metal complex oxides including LiAlO₂, Li₂SiO₃, Li₂TiO₃, Na₂Al₂₂O₃₄, NaFeO₂, Na₄SiO₄, K₂SiO₃, K₂TiO₃, K₂WO₄, Rb₂CrO₄, Cs₂CrO₄, MgAl₂O₄, MgFe₂O₄, MgTiO₃, CaTiO₃, CaWO₄, CaZrO₃, SrFe₁₂O₁₉, SrTiO₃, SrZrO₃, BaAl₂O₄, BaFe₁₂O₁₉, BaTiO₃, Y₃A₁₅O₁₂, Y₃Fe₅O₁₂, LaFeO₃, La₃Fe₅O₁₂, La₂Ti₂O₇, CeSnO₄, CeTiO₄, Sm₃Fe₅O₁₂, EuFeO₃, Eu₃Fe₅O₁₂, GdFeO₃, Gd₃Fe₅O₁₂, DyFeO₃, Dy₃Fe₅O₁₂, HoFeO₃, Ho₃Fe₅O₁₂, ErFeO₃, Er₃Fe₅O₁₂, Tm₃Fe₅O₁₂, LuFeO₃, Lu₃Fe₅O₁₂, NiTiO₃, Al₂TiO₃, FeTiO₃, BaZrO₃, LiZrO₃, MgZrO₃, HfTiO₄, NH₄VO₃, AgVO₃, LiVO₃, BaNb₂O₆, NaNbO₃, SrNb₂O₆, KTaO₃, NaTaO₃, SrTa₂O₆, CuCr₂O₄, Ag₂CrO₄, BaCrO₄, K₂MoO₄, Na₂MoO₄, NiMoO₄, BaWO₄, Na₂WO₄, SrWO₄, MnCr₂O₄, MnFe₂O₄, MnTiO₃, MnWO₄, CoFe₂O₄, ZnFe₂O₄, FeWO₄, CoMoO₄, CuTiO₃, CuWO₄, Ag₂MoO₄, Ag₂WO₄, ZnAl₂O₄, ZnMoO₄, ZnWO₄, CdSnO₃, CdTiO₃, CdMoO₄, CdWO₄, NaAlO₂, MgAl₂O₄, SrAl₂O₄, Gd₃Ga₅O₁₂, InFeO₃, MgIn₂O₄, Al₂TiO₅, FeTiO₃, MgTiO₃, Na₂SiO₃, CaSiO₃, ZrSiO₄, K₂GeO₃, Li₂GeO₃, Na₂GeO₃, Bi₂Sn₃O₉, MgSnO₃, SrSnO₃, PbSiO₃, PbMoO₄, PbTiO₃, SnO₂-Sb₂O₃, CuSeO₄, Na₂SeO₃, ZnSeO₃, K₂TeO₃, K₂TeO₄, Na₂TeO₃, Na₂TeO₄.

Further, the insulation film is not limited to metal oxides, but may be sulfide such as FeS, Al₂S₃, MgS, and ZnS, fluoride such as LiF, MgF₂, and SmF₃, chloride such as HgCl, FeCl₂, CrCl₃, bromide such as AgBr, CuBr, MnBr₂, iodide such as PbI₂, CuI, FeI₂, and metal oxide nitride such as SiAlON. Further, it is not limited to metals and metal compounds, but may be organic materials such as polymer-based materials including polyimide, polyamide, polyester, polyacrylate, epoxy resin, phenol resin, and polyvinyl alcohol.

Materials may not be limited specifically, but may be applicable for the source electrode 58 and/or the drain electrode 60 as long as they have enough conductivity. For example, materials include metal single substances, lamination or their compounds such as Pt, Au, W, Ru, Ir, Al, Sc, Ti, V, Mn, Fe, Co, Ni, Zn, Ga, Y, Zr, Nb, Mo, Te, Rh, Pd, Ag, Cd, Ln, Sn, Ta, Re, Os, Tl, Pb, La, Ce, Pr, Nd, Pm, Sm, Eu, Gd, Tb, Dy, Ho, Er, Tm, Yb, Lu, etc. may be included. Further, metal oxides such as ITO and IZO, or organic conductive materials containing conjugated polymer compounds of such as polyaniline, polythiophene, and polypyrole may be used.

The source electrode 58 and the drain electrode 60 may be manufactured by general methods. A spattering method, a CVD method, etc. are cited but not specifically limited. Appropriate methods may be appropriately employed. For example, general methods for forming thin films including vacuum evaporation method, ion plating, sol-gel method, spraying method, spin coating method, CVD, and lift-off may be applicable.

Materials of the organic semiconductor 56 may be organic materials such as pentacene having semiconductor property but not specifically limited. Used are, for example, phthalocyanine-based derivative; naphthalocyanine-based derivative; azo compound-based derivative; perylene-based derivative; indigo-based derivative; quinacridone-based derivative; polycyclic quinon-based derivative such as anthraquinone; cyanine derivative; fullerene derivative; or nitrogen-containing cyclic compound derivatives including indole, carbazole, oxazole, inoxazole, thiazole, imidazole, pyrazole, oxaadiazole, pyrazoline, thiazole, and triazole; hydrazine derivative; triphenylamine derivative; triphenylmethane derivative; quinine compound derivative including stilbene, anthraquinonediphenoquinone, etc.; and cyclic aromatic compound derivative including anthracene, pyrene, phenanthrene, and coronene; and those having structure in which they are used in main chains in polymers or combined in the pendant form as a side chain, such as polyethylene chain, polysiloxane chain, polyether chain, polyester chain, polyamide chain, and polyimide chain; or carbon-based conjugated polymer such as complex type conjugated polymer having the structure in which constituent unit is alternately combined in the conjugated polymer including aromatic-based conjugated polymer such as polyparaphenylene; aliphatic-based conjugated polymer such as polyacetylene; heterocyclic conjugated polymer such as polypynole and polythiophene, heteroatom-containing conjugated polymer such as polyaniline and polyphenylene sulfide, or conjugated polymer such as poly(phenylenevinylene), poly(anilenevinylene) and poly(thienylenevinylene). Further used are polymers in which carbon-based conjugated structure is alternately chained with oligosilane such as disilanylene carbon-based conjugated polymer structure such as polysilane and disilanyleneallylene polymer, (disilanylene)ethenylene polymer, and (disilanylene)ethynylene polymer. Besides, used are polymer chain made of inorganic element such as phosphorous base and nitrogen base, polymers coordinated with aromatic ligand of polymer chain such as phthalocyanate polysiloxane, polymer in which perylene such as perylenetetracarboxylic acid is condensed by heat treatment, ladder-type polymers which are obtained by heat-treating polyethylene derivative having cyano group such as polyacrylonitrile, and complex materials in which provskite is intercalated with organic compound.

As for a method for forming the organic semiconductor 56, a vacuum evaporation method, etc. may be cited but not specifically limited. Appropriate methods may be appropriately employed. For example, general methods for forming thin films including ion plating, sol-gel method, spraying method, and spin coating method may be applicable.

### <Interlayer Insulation Film>

As for the interlayer insulation film 72 and the interlayer insulation film 74, the interlayer insulation film 72 on the organic TFT and the interlayer insulation film 74 on the right end side of the organic EL element may be formed simultaneously or individually. Materials forming each interlayer insulation film may not be specifically limited and material type may be different from each other. And the interlayer insulation film 74 may be appropriately omitted.

Although materials forming the interlayer insulation films may not be specifically limited, either of inorganic materials and organic materials may be used. For example, effective are metal oxides including LiOx, LiNx, NaOx, KOx, RbOx, CsOx, BeOx, MgOx, MgNx, CaOx, CaNx, SrOx, BaOx, ScOx, YOx, YNx, LaOx, LaNx, CeOx, PrOx, NdOx, SmOx, EuOx, GdOx, TbOx, DyOx, HoOx, ErOx, TmOx, YbOx, LuOx, TiOx, TiNx, ZrOx, ZrNx, HfOx, HfNx, ThOx, VOx, VNx, NbOx, TaOx, TaNx, CrOx, CrNx, MoOx, MoNx, WOx, WNx, MnOx, ReOx, FeOx, FeNx, RuOx, OsOx, CoOx, RhOx, IrOx, NiOx, PdOx, PtOx, CuOx, CuNx, AgOx, AuOx, ZnOx, CdOx, HgOx, BOx, BNx, AlOx, AlNx, GaOx, GaNx, InOx, TiOx, TiNx, SiNx, GeOx, SnOx, PbOx, POx, PNx, AsOx, SbOx, SeOx, TeOx; metal complex oxides including LiAlO₂, Li₂SiO₃, Li₂TiO₃, Na₂Al₂₂O₃₄, NaFeO₂, Na₄SiO₄, K₂SiO₃, K₂TiO₃, K₂WO₄, Rb₂CrO₄, Cs₂CrO₄, MgAl₂O₄, MgFe₂O₄, MgTiO₃, CaTiO₃, CaWO₄, CaZrO₃, SrFe₁₂O₁₉, SrTiO₃, SrZrO₃, BaAl₂O₄, BaFe₁₂O₁₉, BaTiO₃, Y₃A₁₅O₁₂, Y₃Fe₅O₁₂, LaFeO₃, La₃Fe₅O₁₂, La₂Ti₂O₇, CeSnO₄, CeTiO₄, Sm₃Fe₅O₁₂, EuFeO₃, Eu₃Fe₅O₁₂, GdFeO₃, Gd₃Fe₅O₁₂, DyFeO₃, DY₃Fe₅O₁₂, HoFeO₃, Ho₃Fe₅O₁₂, ErFeO₃, Er₃Fe₅O₁₂, Tm₃Fe₅O₁₂, LuFeO₃, Lu₃Fe₅O₁₂, NiTiO₃, Al₂TiO₃, FeTiO₃, BaZrO₃, LiZᵣO₃, MgZrO₃, HfTiO₄, NH₄VO₃, AgVO₃, LiVO₃, BaNb₂O₆, NaNbO₃, SrNb₂O₆, KTaO₃, NaTaO₃, SrTa₂O₆, CuCr₂O₄, Ag₂CrO₄, BaCrO₄, K₂MoO₄, Na₂MoO₄, NiMoO₄, BaWO₄, Na₂WO₄, SrWO₄, MnCr₂O₄, MnFe₂O₄, MnTiO₃, MnWO₄, CoFe₂O₄, ZnFe₂O₄, FeWO₄, CoMoO₄, CuTiO₃, CuWO₄, Ag₂MoO₄, Ag₂WO₄, ZnAl₂O₄, ZnMoO₄, ZnWO₄, CdSnO₃, CdTiO₃, CdMoO₄, CdWO₄, NaAlO₂, MgAl₂O₄, SrAl₂O₄, Gd₃Ga₅O₁₂, InFeO₃, MgIn₂O₄, Al₂TiO₅, FeTiO₃, MgTiO₃, Na₂SiO₃, CaSiO₃, ZrSiO₄, K₂GeO₃, Li₂GeO₃, Na₂GeO₃, Bi₂Sn₃O₉, MgSnO₃, SrSnO₃, PbSiO₃, PbMoO₄, PbTiO₃, SnO₂-Sb₂O₃, CuSeO₄, Na₂SeO₃, ZnSeO₃, K₂TeO₃, K₂TeO₄, Na₂TeO₃, Na₂TeO₄; sulfides including FeS, Al₂S₃, MgS, and ZnS; fluorides including LiF, MgF₂, and SmF₃; chlorides including HgCl, FeCl₂, and CrCl₃; bromides including AgBr, CuBr, and MnBr₂; iodides including PbI₂, CuI, FeI₂; or metal oxide nitrides including SiAlON. Further, also effective may be polymer-based materials including polyimide, polyamide, polyester, polyacrylate, epoxy resin, phenol resin, and polyvinyl alcohol.

With regard to a method manufacturing interlayer insulation films, preferable may be a method manufacturing without emitting at least one of electromagnetic wave and particle beam, specifically particle beam and ray having shorter wavelength thanvisible ray, so as to prevent the organic TFT 50 from damage. For example, general methods for forming thin film such as sol-gel method, spin coating method, spraying method, vacuum evaporation method may be also possible.

### <Conductive Layer>

The conductive layer is the negative electrode 18 which is the upper electrode of the organic EL element 100. In the present embodiment, the negative electrode 18 which is the upper electrode of the organic EL element 100 is extended to cover the surface of the interlayer insulation film 72 and protect the organic TFT from at least one of electromagnetic wave and particle beam. Electromagnetic waves are to cause damage to layers forming the organic TFT, and they are for example infrared ray, visible ray, and rays having shorter wavelength than visible ray. And particle beams are to cause damage to layers forming the organic TFT, and they are for example alpha ray, beta ray, and neutron ray. Further, to protect the organic TFT from at least one of the electromagnetic wave and the particle beam is a concept that includes protecting the organic TFT from at least one of electromagnetic wave and particle beam by at least one mode of shielding, absorption, and reflection.

The conductive layer is not limited as long as the layer has conductivity. The conductive layer having conductivity is preferable because the conductive layer is convertible with the electrode of the organic EL element 50 or has characteristics to discharge shielding against electromagnetic wave and/or particle beam, heat, and electric charge.

For example, the conductive layer is formed of conductive coating material. The conductive coating material may be any one that can apply conductivity, and a coating material dispersing conductive powder to binder resin, and a coating material made of organic metal compound and a coating material made of organic conductive resin may be used. As for the conductive coating material, a type of coating material using non-solvent may be possible as well as material using solvent.

As for the binder resin, used may be a mixture of one or more types of cellulose-based resin including nitrocellulose, acetyl cellulose, cellulose acetate propionate; acrylic resin including poly(metha)butyl acrylate; polyvinyl chloride acetate copolymer; polyester resin; polyvinyl butyral; and polyurethane resin.

As for conductive powder, used may be metal particles including gold, silver, copper, stainless, aluminum, zinc, tin indium, antimony, and nickel; conductive pigment including carbon black, and black lead; metal oxides including zinc oxide, tin oxide, indium oxide, and titan oxide; and fine carbon fiber including carbon nanotube, and fullerenes. Shapes of the conductive powder are not limited specifically but shapes of globe, ellipsoid, scale, and needle may be used. As for the organic metal compound, used may be organic silver compounds including methyl silver, butyl silver, and phenyl silver; and organic metal compounds including monoalkyl(aryl) gold derivative (ethyl dibromide gold, dichloride phenyl gold, etc.), dialkyl gold derivative, and trialkyl gold derivative. As for the organic conductive resin, used may be organic compounds having pi-conjugated system combination including polyaniline and polythiophene.

These conductive powder, organic metal compound, and organic conductive resin may be used individually or in combination. The conductive coating material may be added with other additives, for example, curing agent, leveling agent, antifoaming agent, and viscosity modifier.

As in the present embodiment, when the conductive layer is convertible with the negative electrode 18, the process in which they are produced together is easy and preferable. However, this is not limited and they may not be convertible but may be formed in discontinuous manner. Further the conductive layer may be convertible with the positive electrode, and for example, in the case of top emission type, it is preferable to form the conductive layer convertible with the positive electrode in view of derivation.

As in the present embodiment, it is preferable because particle beam and a visible ray, rays having shorter wavelength than visible ray protect at least one of electromagnetic wave to prevent from causing damage to the organic TFT 50. It is more preferable to protect the organic TFT 50 from these short-wavelength rays because they tend to cause more damage to the organic TFT 50 as the wavelength becomes short, such as blue ray, purple ray, ultraviolet ray, and X-ray.

As in the present embodiment, as for the conductive layer, it is preferable because a color transparent layer or opaque layer having a clearness degree lower than translucence is easy to protect the organic TFT 50 from electromagnetic wave. However, this is not limited, but color having higher absorption of electromagnetic wave and/or particle beam is preferable, particularly black is preferable. Transparent and colorless may be possible as long as the layer contains light absorbing agent and particle beam absorbing agent.

Further, as in the present embodiment, the conductive layers having metal luster of metals such as Al, specularity, electromagnetic reflexivity are preferable in view of protection for the organic TFT and light extract effect of the organic EL element. Even the case of other than metals, metal luster may be provided by print ink of metallic tone such as silver and gold, which is added with metal pigment such as aluminum paste and aluminum powder.

As for the method for forming the conductive layer, preferable is a method to emit particle beam and electromagnetic waves as little as possible so not to cause damage to the organic TFT 50. For example, general methods for forming thin films such as methods of ion plating, sol-gel, spraying, spin coating, and vacuum evaporation may be possible.

### <Protection Layer>

The protection film 20 may have a multilayer structure or a single layer structure and may be an inorganic film or an organic film. However, the film including inorganic film is preferable because erosion due to moisture and oxygen increases barrier properties.

As for the inorganic film, for example, nitride film, oxide film, carbon film, or silicon film may be employed. Particularly, silicon nitride film, silicon oxide film, silicon oxide nitride film, or diamond like carbon (DLC) film, amorphous carbon film are cited. That is, cited are nitride such as SiN, AIN, and GaN; oxides such as SiO, Al₂O₃, Ta₂O₅, ZnO, and GeO; oxide nitride such as SiON; carbide nitride such as SiCN; metal fluoride compound; and metal film.

As for the organic film, cited are, for example, furane film, pyrrole film, thiophene film, polyparaxylene film, epoxy resin, acrylic resin, polyparaxylene, fluorine polymer (perfluoroolefin, perfluoroether, tetrafluoroethylene, chlorotrifluoroethylene, dichlorodifluoroethylene, etc.), or polymerized film such as metal alkoxide (CH₃OM, C₂H₅OM, etc.), polyimide precursor, perylene-based compound, etc.

As for the protection film 20, cited are a laminated structure composed of not less than two kinds of materials, a laminated structure composed of inorganic protection film, silane coupling layer, resin sealing film, a laminated structure composed of a barrier layer formed of an inorganic material and a cover layer formed of an organic material, a laminated structure composed of a compound of organics and semiconductor or metals such as Si-CXHY, and inorganic, a laminated structure in which inorganic and organic films are alternately laminated, a laminated structure in which SiO₂ or Si₃N₄ is laid on a Si layer, etc.

The barrier film 12 and the protection film 20 have a function to mainly protect the organic EL element 100 from outside air (such as oxygen) and moisture by the component inorganic film which mainly blocks outside air (such as oxygen) and moisture. Here the barrier film 12 has a main function to block outside air (such as oxygen) and moisture from the side of the substrate 10 and the protection film 20 has a main function to block a portion not covered with the organic EL element 100 from outside air (such as oxygen) and moisture.

In the barrier film 12 and the protection film 20, the component organic film fills in pinholes and surface unevenness formed in the inorganic film to level the surface. It also functions to reduce film stress of the inorganic film.

Methods for manufacturing the protection film 20 may include spattering method and CVD method. However, they are not limited but appropriate methods may be used appropriately. For example, general methods for forming thin film such as vacuum evaporation, ion plating, sol-gel method, spraying method, spin coating method, and CVD may be also possible.

Other layers are not hindered from forming respectively between the insulation film 72, the conductive layer 18, and the protection film 20. Meaning of forming on the layer or on the layer surface includes both concepts that the layer may be formed directly on the surface and indirectly on the surface through the other layer as long as it is upper layer of the layer.

### <Luminescence Mode of the Organic EL Display Device>

Luminescence mode of the above-mentioned organic EL display device P1 will be described.

In the case of the organic TFT formed of p-type organic semiconductor, when the gate electrode 52 is applied with negative voltage, electron holes are generated on the interface (area about several nm) between the gate insulation film 54 and the organic semiconductor 56. When voltage is applied between the source electrode 58 and the drain electrode 60 after the electron holes are generated, the electron holes can be transported. Meanwhile, when voltage is not applied between the gate electrode 52 and the source electrode 58, the electron holes are not transported. Thus switching can be performed by applying a conduction state (switch on) and a non-conduction state (switch off).

The electron holes are supplied from the source electrode 58 to the drain electrode 60 through the gate insulation film 54. The electrode holes are transferred to the positive electrode 14 of the organic EL element 100 through the drain electrode 60.

In the organic EL element 100, the electron holes are transported from the positive electrode 14 to the electron hole injection layer 162 of the organic solid layer 16. The electron holes thus transported are injected into the electron hole transport layer 164. The electron holes thus injected into the electron hole transport layer 164 are transported into the luminescent layer 166.

Further, in the organic EL element 100, electrons are injected from the negative electrode 18 into the electron injection layer 168 of the organic solid layer 16. The electrons thus injected are transported into the luminescent layer 166 through the electron transport layer 167.

The electron holes and electrons thus transported are recombined in the luminescent layer 166. Luminescence due to EL is emitted by energy generated during the recombination. This luminescence is derived toward outside through the electron hole transport layer 164, the electron hole injection layer 162, the positive electrode 14, the barrier film 12 and the substrate 10 in order respectively so that the luminescence becomes visible.

In the case that Al is used for the negative electrode 18, the interface between the negative electrode layer 18 and the electron injection layer 168 becomes a reflecting surface on which they are reflected and proceed to the side of the positive electrode 14 and penetrate the substrate 10 to eject outside. Therefore, when the organic EL element having the above configurations is employed for displays, the side of the substrate 10 becomes a viewing surface.

For example, when full color display is realized with the organic EL panel, cited are a manufacturing method in which the organic EL element emitting each color light of RGB are separately coated (separate coating method), a method of combination of an organic EL element emitting single white color and a color filter (color filter method), a method of combination of an organic EL element emitting a single color such as blue or white and a color converting layer (color converting method), and a method in which a single color organic EL element realizes multiple luminescence by irradiating electromagnetic wave to the organic luminescent layer and others (photo bleaching method). However, they are not specifically limited.

According to the present embodiment in which the conductive layer is provided, the organic TFT can be protected more from particle beam and electromagnetic waves causing damage to the organic TFT. Therefore, it is more reliable even though using other manufacturing process in which the organic EL display device P1 generating particle beam and electromagnetic waves causing damage to the organic TFT and using long by consumers.

### [Method of Manufacturing Organic EL Display Device]

A method of manufacturing the organic EL display device P1 shown in FIG. 2 will be described. On the substrate 10, the barrier film 12 is formed and then the organic TFT 50 and the positive electrode 14 of the organic EL element 100 are formed. The drain electrode 60 of the organic TFT 50 and the positive electrode 14 of the organic EL element 100 are formed so as to contact with each other for electrical conduction.

Next, the interlayer insulation film 72 located on the left end side of the sheet of the organic EL element 100 is formed so as to cover the surface of the organic TFT 50. And the interlayer insulation film 74 located on the right end side of the organic EL element 100 is formed so as to cover the positive electrode 14.

After forming these interlayer insulation films, the negative electrode 18 and the organic solid layer 16 of the organic EL element 100 are formed. The negative electrode 18 is formed to extend to a top of the interlayer insulation film so as to cover the organic TFT 50.

After the negative electrode 18 is formed, the protection film 20 is formed so as to cover the surface to manufacture the organic EL display device P1.

According to the present embodiment, especially in the case that particle beam and electromagnetic waves are produced by a method of forming the protection film 20 which is a vacuum process and others such as CVD, the negative electrode 18 which is a conductive layer protects from the particle beam and electromagnetic waves causing damage to these organic TFT 50, so that the organic EL display device P1 including the less-damaged organic TFT 50 can be provided.

With regard to a method of manufacturing each layer, applicable printing method may include gravure coating, gravure reverse coating, comma coating, die coating, lip coating, cast coating, roll coating, air knife coating, mayer bar coating, extrusion coating, offset, ultraviolet cure offset, flexo, hole plate, silk, curtain flow coating, wire bar coating, reverse coating, gravure coating, kiss coating, blade coating, smooth coating, spray coating, flow coating, and brush coating. And lower layer and its upper layer may be double laid in wet condition and then dried, as well as the lower layer is formed in dry condition and then coated over.

### [Other Embodiment 1]

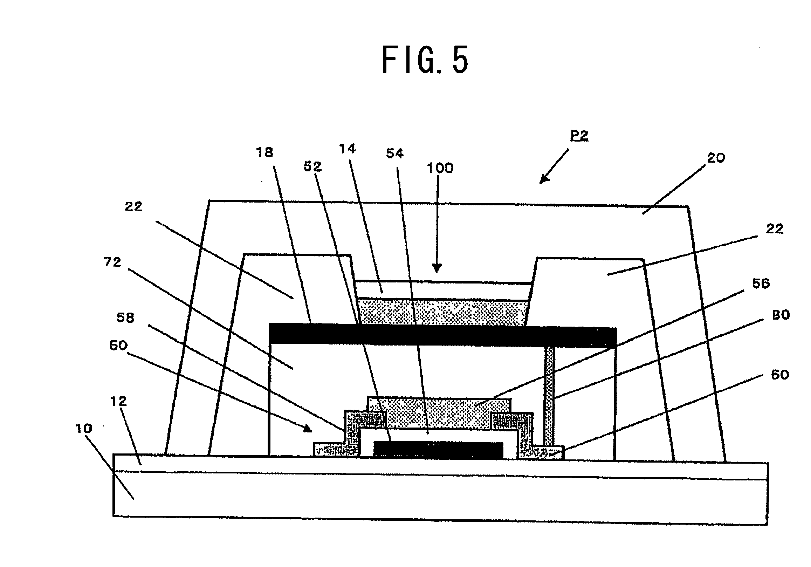

FIG. 5 shows the organic EL display device P2 in Embodiment 1 related to the present embodiment. Since the same numeral references hereinafter are similar to those of the above-mentioned embodiment, description is omitted.

An organic EL element 100 having a top emission structure is disposed on the organic TFT 50, and the organic EL element 100 and the organic TFT 50 are covered with the protection film 20. The negative electrode 18 of the organic EL element is formed so as to cover the interlayer insulation film on the organic TFT. The organic semiconductor layer 56 of the organic TFT 50 is made of n-type organic semiconductor. The drain electrode 60 and the negative electrode 18 are electrically connected by the through-hole 80 which is a charge transport path provided in the interlayer insulation film 72.

A method of manufacturing the organic EL display device P2 will be described. The barrier film 12 is formed on the substrate 10 to produce the organic TFT 50. The interlayer insulation film 72 is formed so as to cover the surface of the organic TFT 50 to produce a through hole 80. Next, the negative electrode 18 is formed. Then the insulation film 22 for protecting from short circuit between the negative electrode and the positive electrode is formed on the end of the organic EL element. And the organic EL element 100 is formed.

Finally, the protection film 20 is formed so as to entirely cover the organic EL element and the organic TFT to produce the organic EL display device P2.

According to the present embodiment, in the case that at least one of electromagnetic waves and particle beam are generated by a method of forming the protection film 20 which is a vacuum process such as CVD, the negative electrode 18 which is a conductive layer protects from at least one of the particle beam and electromagnetic waves causing damage to these organic TFT 50, so that the organic EL display device P2 including the less-damaged organic TFT 50 can be provided.

### [Other Embodiment 2]

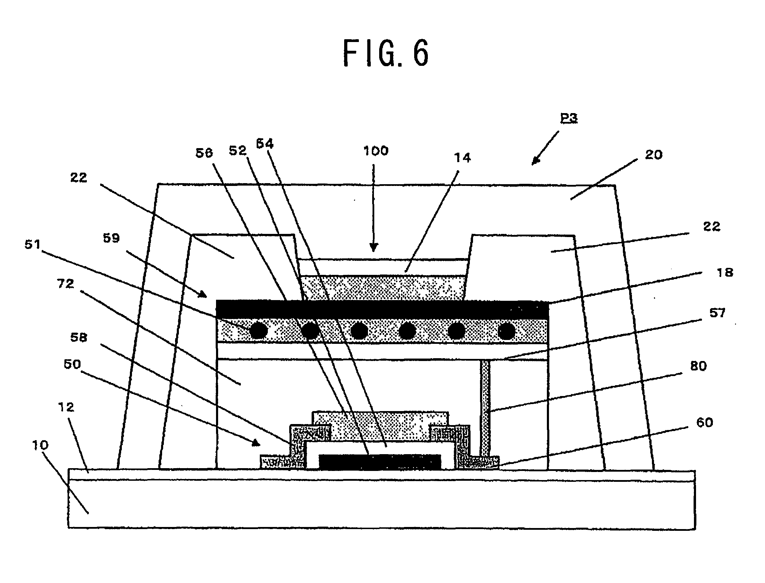

FIG. 6 shows the organic EL display device P3 of the other embodiment 2 related to the present embodiment.

The organic TFT 59 for driving is arranged on the organic TFT 50 for switching, the top-contact-type organic EL element 100 is arranged on the organic TFT 59, and the organic EL element 100, the organic TFT 50, and the organic TFT 59 are covered with the protection film 20. In the case that the driving transistor is a static induction transistor (SIT) as in FIG. 6, the drain electrode of the organic TFT 59 is made to entirely cover the organic TFT 50 and the organic TFT 59. The semiconductor layer of the organic TFT 50 and the organic TFT 59 is a n-type organic semiconductor. The organic TFT 59 is composed of the source electrode 57/gate electrode 51/drain electrode (the positive electrode 14 of the organic EL element 100).

The drain electrode 60 and the source electrode 57 of the organic TFT 59 are electrically connected by the through hole 80 which is an electron hole transport path provided in the interlayer insulation film 72.

A method of manufacturing the organic EL display device P3 will be described. The barrier film 12 is formed on the substrate 10 to produce the organic TFT 50 for switching. The interlayer insulation film 72 is formed so as to cover the surface of the organic TFT 50 to produce the through hole 80. Next, the organic TFT 59 for driving is formed. Then the insulation film 22 for protecting the end of the organic EL element from short circuit is formed. And the organic EL element 100 is formed on the organic TFT 59.

Finally, the protection film 20 is formed so as to entirely cover the organic EL element and the organic TFT to produce the organic EL display device P3.

According to the present embodiment, in the case that particle beam and electromagnetic waves are generated by a method of forming the protection film 20 which is a vacuum process such as CVD, the positive electrode 14 which is a conductive layer protects from the particle beam and electromagnetic waves causing damage to these organic TFT 50, so that the organic EL display device P3 including the less-damaged organic TFT 50 can be provided.

The negative electrode 18 or the drain electrode of the organic TFT 59 has reflexivity to at least one of the electromagnetic wave and the particle beam and is preferable for protecting from at least one of the electromagnetic wave and the particle beam causing damage to the organic TFT 50.

### [Organic Transistor]

In the above-mentioned embodiment, the organic EL display device including the organic EL element is shown but this is not limited. Even the case of the organic transistor driving others than the organic EL element, a configuration of protecting at least one of the electromagnetic wave and the particle beam by the conductive layer according to the present embodiment is applicable. That is, in the above-mentioned embodiment, the organic EL element may be replaced with an other driving element driven by the organic transistor or the driving element such as the organic EL element may be omitted and formed as a single organic transistor. Regardless of direction and indirection, the conductive layer may be formed on the surface of them and the protection film may be formed on the conductive layer.

Such an organic transistor may be applied for displays in general, e.g. LCD displays, electrophoretic displays, electronic paper, and toner displays.

### Embodiment

Materials of the embodiment are described below.

Source/drain electrode: Cr/Au
Gate electrode: Ta, Gate insulation film: Ta₂O₅
Interlayer insulation film: PVA
Conductive layer: Al
Organic semiconductor: Pentacene
Organic EL positive electrode: ITO
Organic EL organic solid layer:
   Hole injection layer (CuPc)
   Hole transport layer (NPB)
   Luminescent layer (Alq₃)
   Electron transport layer (Alq₃)
   Electron injection layer (Li₂O)
Organic EL negative electrode: Al
Protection film: SiNx
The organic EL display device P1 as the embodiment is produced and compared with the conventional organic EL display device.

### [Manufacturing Method]

In the manufacturing method of the embodiment, a Ta film as the gate electrode is formed on a plastic film substrate by a sputtering method at thickness of 2000 Å to form wiring pattern. This is anodized to obtain the gate insulation film Ta₂O₅. Further, Au film of 100nm thickness having an adhesion layer of 5nm Cr film is formed by lift-off as source and drain electrodes. And subsequently ITO as a positive electrode of the organic EL element is formed so as to contact with the drain electrode of the organic TFT. And then pentacene is film-formed by a vacuum evaporating method as the organic semiconductor layer. Then the interlayer insulation film PVA (polyvinyl alcohol) having sufficient thickness is produced so as to entirely cover the organic TFT. This insulation film is subjected by patterning so as to cover the end portion of the organic EL element for protecting the organic EL element from short circuit of the positive electrode and negative electrode. And after the organic layer of the organic EL element is film-formed, the negative electrode Al is also film-formed on the organic TFT as well as the organic EL element. Finally, SiNx is film-formed by plasma CVD method as a protection film of the organic layer for protecting from moisture and gas from outside.

### [Evaluation]

In a manufacturing method of the comparative example, interlayer insulation film on the organic TFT and the negative electrode of the organic EL element are both not film-formed panels and the remaining is similar with the embodiment.

Result of comparison in semiconductor property (mobility, on-off property) between the organic TFT produced according to the embodiment and the comparative example is shown in Table 1 below.

**[Table 1]**

| | Mobility (cm²/Vs) | On/off |
|---|---|---|
| Embodiment | 0.3 | 10⁶ |
| Comparative Example | 0.004 | 10³ |

### [Remarks]

The organic EL display device of the embodiment can obtain excellent semiconductor property (mobility, on-off property) compared with the comparative example.

## Claims

1. An organic EL display device comprising an organic EL element which is provided with at least a positive electrode, an organic luminescent layer, and a negative electrode, and an organic transistor which drives the organic EL element, comprising:
a protection film for covering the organic transistor to protect at least the organic transistor;
a conductive layer having conductivity, in respect between the protection film and a surface of the organic transistor; and
an insulation film for insulating for the conductive layer and the surface of the organic transistor, formed on the side of the surface of the organic transistor but the conductive layer.

2. The organic EL display device according to Claim 1, wherein the conductive layer is a layer which protects the organic transistor from at least electromagnetic wave and particle beam.

3. The organic EL display device according to Claim 1 or 2, wherein the conductive layer is a color transparent layer or opaque layer.

4. The organic EL display device according to any one of Claims 1 to 3, wherein the conductive layer is a layer which has at least one of reflexivity and absorptivity in respect of at least one of electromagnetic wave and particle beam.

5. The organic EL display device according to any one of Claims 1 to 4, wherein the conductive layer is convertible with some portion of at least one of positive electrode and negative electrode of the organic EL element.

6. The organic EL display device according to Claim 5, wherein at least one of positive electrode and negative electrode of the organic EL element extends longer up to the surface of the insulation film to make the conductive layer convertible.

7. The organic EL display device according to any one of Claims 1 to 6, wherein the conductive layer is connected with at least one of a drain electrode and a source electrode of the organic transistor.

8. The organic EL display device according to any one of Claims 1 to 7, wherein the organic EL element is formed on the organic transistor.

9. A method of manufacturing an organic EL display device comprising an organic EL element which is provided with at least a positive electrode, an organic luminescent layer, and a negative electrode and an organic transistor which drives the organic EL element, the method of manufacturing the organic EL display device comprising steps of:
forming an insulation film for insulating the conductive layer and the surface of the organic transistor;
forming a conductive layer on the insulation film; and
forming a protection film for protecting the organic transistor on the conductive layer.

10. The method of manufacturing the organic EL display device according to Claim 9, wherein the conductive layer is a layer which protects the organic transistor from at least one of electromagnetic wave and particle beam.

11. The method of manufacturing the organic EL display device according to Claim 9 or 10, wherein the conductive layer is a color transparent layer or opaque layer which has clearness degree of lower than translucence.

12. The method of manufacturing the organic EL display device according to any one of Claims 9 to 11, wherein the conductive layer is a layer which has at least one of reflexivity and absorptivity in respect of at least one of electromagnetic wave and particle beam.

13. The method of manufacturing the organic EL display device according to any one of Claims 9 to 12, wherein the conductive layer is at least one of positive electrode and negative electrode of the organic EL element and the conductive layer is convertible with at least some portion.

14. A method of manufacturing the organic EL display device according to Claim 13, wherein at least one of the positive electrode and the negative electrode of the organic EL element extends longer up to the surface of the insulation film to make convertible.

15. An organic transistor comprising a protection film for covering the organic transistor to protect at least the organic transistor, comprising
a conductive layer having conductivity, in respect between the protection film and a surface of the organic transistor; and
an insulation film for insulating the conductive layer and the surface of the organic transistor, formed on the side of the surface of the organic transistor but the conductive layer.

16. The organic transistor according to Claim 15, wherein the conductive layer is a layer which protects the organic transistor from at least one of electromagnetic wave and particle beam.

17. The organic transistor according to Claim 15 or 16, wherein the conductive layer is a color transparent layer or opaque layer.

18. The organic transistor according any one of Claims 15 to 17, wherein the conductive layer is a layer which has at least one of reflexivity and absorptivity in respect of at least one of electromagnetic wave and particle beam.

19. The organic transistor according to any one of Claims 15 to 18, wherein the conductive layer is a layer which is convertible with some portion of at lest one of the positive electrode and the negative electrode of the organic EL element.

20. The organic transistor according to Claims 19, wherein at least one of the positive electrode and the negative electrode of the organic EL element extends longer up to the surface of the insulation film to make convertible.

21. The organic transistor according to any one of Claims 15 to 20, wherein the conductive layer is connected with at least one of a drain electrode and a source electrode of the organic transistor.

22. A method of manufacturing an organic transistor comprising steps of:
forming an insulation film for insulating the conductive layer and the surface of the organic transistor;
forming the conductive layer on the insulation film; and
forming a protection film for protecting the organic transistor on the conductive layer.

23. The method of manufacturing the organic transistor according to Claim 22, wherein the conductive layer is a layer which protects the organic transistor from at least one of electromagnetic wave and particle beam.

24. The method of manufacturing the organic transistor according to Claim 22 or 23, wherein the conductive layer is a color transparent layer or opaque layer which has clearness degree of lower than translucence.

25. The method of manufacturing the organic transistor according to any one of Claims 22 to 24, wherein the conductive layer is a layer which has at least one of reflexivity and absorptivity in respect of at least one of electromagnetic wave and particle beam.

26. The method of manufacturing the organic transistor according to any one of Claims 22 to 25, wherein the conductive layer is at least one of the positive electrode and the negative electrode of the organic EL element and the conductive layer is convertible with at least of some portion.

27. The method of manufacturing the organic EL display device according to Claim 26, wherein at least one of the positive electrode and the negative electrode of the organic EL element extends longer up to the surface of the insulation film to make convertible.
